# EUROPÄISCHE PATENTSCHRIFT

(11) **EP 2 208 405 B1**
(45) Veröffentlichungstag und Bekanntmachung des Hinweises auf die Patenterteilung: **18.05.2011**
(21) Anmeldenummer: 08845428.5
(22) Anmeldetag: 03.11.2008
(51) Int. Cl.: H05K 1/11, H05K 1/14

(54) **ANORDNUNG ZUR VERBINDUNG VON LEITERPLATTEN**
ASSEMBLY FOR INTERCONNECTING CIRCUIT BOARDS
ENSEMBLE POUR L'INTERCONNEXION DE CARTES DE CIRCUITS

(30) Priorität: 02.11.2007 EP 07075955
(43) Veröffentlichungstag der Anmeldung: 21.07.2010
(73) Patentinhaber: Cinterion Wireless Modules GmbH, 81669 München (DE)
(72) Erfinder: WENDLER, Ralf, 14612 Falkensee (DE); ROMAHN, Jörg, 12353 Berlin (DE); BÖLCKE, Annette, 13469 Berlin (DE)
(74) Vertreter: Eisenführ, Speiser & Partner
(86) Internationale Anmeldenummer: PCT/EP2008/064878
(87) Internationale Veröffentlichungsnummer: WO 2009/056645

(56) Entgegenhaltungen:
- DE-A1-102005 017 849
- US-A- 5 791 911
- HEATH R E ET AL: "COAXIAL CONNECTOR" IBM TECHNICAL DISCLOSURE BULLETIN, IBM CORP. NEW YORK, US, Bd. 10, Nr. 21, März 1979 (1979-03), Seiten 3987-3988, XP002075381 ISSN: 0018-8689

## Beschreibung

Die Erfindung betrifft eine Anordnung mindestens zweier Leiterplatten.

Leiterplatten werden mit einer Vielzahl von elektronischen Bauelementen bestückt. Umfasst ein elektrisches Gerät zwei Leiterplatten müssen diese gegebenenfalls elektrisch miteinander verbunden werden, um die Gesamtfunktion des elektrischen Gerätes ausführen zu können". Das Dokument US 5 791 911 A offenbart eine Anordrung, umfassend zwei Leiterplatten und ein Verbindungselement gemäss dem oberbegriff des Anspruchs 1.

Die elektrische Verbindung von zwei Leiterplatten, zum Beispiel von auf Leiterplatten aufgebrachten Hochfrequenzbaugruppen oder einer auf einer Leiterplatte aufgebrachten Hochfrequenzbaugruppe und einer auf der anderen Leiterplatte aufgebrachten Steuerungsbaugruppe, erfolgt durch ein Verbindungselement, z.B. einen Steckverbinder. Dieses Verbindungselement wird in der Regel auf einer Seite auf einer Leiterplatte aufgelötet. Auf der anderen Seite umfassen das Verbindungselement in der Regel Federelemente, die an eine andere Leiterplatte zur Kontaktierung angepresst werden.

Es gibt eine Vielzahl von Verbindungselementen. Je nach Typ, Form, Größe, Zahl der Federelemente etc. muss die Kontaktfläche der anderen, zu kontaktierenden Leiterplatte an das jeweilige Verbindungselement geometrisch angepasst werden, um eine sichere Kontaktierung zu gewährleisten.

Eine vorgegebene Form, Größe etc. eines Verbindungselementes schränkt die Gestaltung der Kontaktfläche der anderen, zu kontaktierenden Leiterplatte ein.

Es ist ein der vorliegenden Erfindung zugrunde liegendes technisches Problem, eine Anordnung von erster Leiterplatte, Verbindungselement und zweiter Leiterplatte anzugeben, bei der eine Vielzahl von Verbindungselementen unterschiedlicher Form und Größe verwendet werden können und die eine sichere Kontaktierung zwischen dem Verbindungselement und den beiden Leiterplatten gewährleistet.

Die Aufgabe wird gelöst durch eine Anordnung, umfassend
- eine erste Leiterplatte, die eine Kontaktfläche zur Kontaktierung eines Verbindungselements aufweist, wobei die Kontaktfläche einen zentralen Kontaktpunkt und einen diesen zentralen Kontaktpunkt umgebenden konzentrischen Ring umfasst;
- eine zweite Leiterplatte; und
- ein Verbindungselement, das an einer ersten Seite mit der zweiten Leiterplatte elektrisch kontaktiert ist und an einer der ersten Seite gegenüber liegenden zweiten Seite ein erstes Federelement und mindestens ein zweites Federelement umfasst, wobei das erste Federelement mit dem zentralen Kontaktpunkt der ersten Leiterplatte und das mindestens eine zweite Federelement mit dem konzentrischen Ring der ersten Leiterplatte elektrisch kontaktiert ist.

Durch die erfindungsgemäße Lösung wird eine Anordnung von erster Leiterplatte, Verbindungselement und zweiter Leiterplatte angegeben, bei der eine Vielzahl von Verbindungselementen unterschiedlicher Form und Größe verwendet werden kann und die eine sichere Kontaktierung zwischen Verbindungselement und den beiden Leiterplatten gewährleistet.

Weiterbildungen der Erfindung ergeben sich aus den Unteransprüchen.

In vorteilhafter Weise wird die Anordnung dadurch weitergebildet, dass das Verbindungselement das erste Federelement und zwei zweite Federelemente umfasst, wobei das erste Federelement mit dem zentralen Kontaktpunkt und die beiden zweiten Federelemente mit dem konzentrischen Ring elektrisch kontaktiert sind. Dadurch lassen sich Verbindungselemente mit drei Federelementen, wobei die einzelnen Federelemente eine Stiftform besitzen, für die Anordnung verwenden.

In weiterhin vorteilhafter Weise wird die Anordnung alternativ zum vorigen Absatz dadurch weitergebildet, dass das zweite Federelement das erste Federelement konzentrisch umgibt. Dadurch lassen sich häufig genutzte koaxiale Verbindungselemente in der Anordnung verwenden.

Die Anordnung kann auch durch weitere Leiterplatten ergänzt werden, wobei jeweils je zwei Leiterplatten und ein Verbindungselement, das diese miteinander verbindet, eine erfindungsgemäße Anordnung, wie oben definiert, bilden.

Weitere Vorteile der Erfindung ergeben sich aus der folgenden Beschreibung, welche in Verbindung mit den beigefügten Zeichnungen die Erfindung anhand von vier Ausführungsbeispielen erläutert.

Dabei zeigt in schematischer Darstellung die
- FIG 1: eine Anordnung mit einem Verbindungselement mit drei Federelementen, und die
- FIG 2: eine erste Leiterplatte mit einer erfindungsgemäßen Kontaktfläche, und die
- FIG 3: die Anordnung aus Figur 1 und die Kontaktfläche aus Figur 2 in Zusammenschau, und die
- FIG 4: die Anordnung aus Figur 3 ohne die zweite Leiterplatte, aber mit einem zur Figur 3 alternativen Verbindungselement .

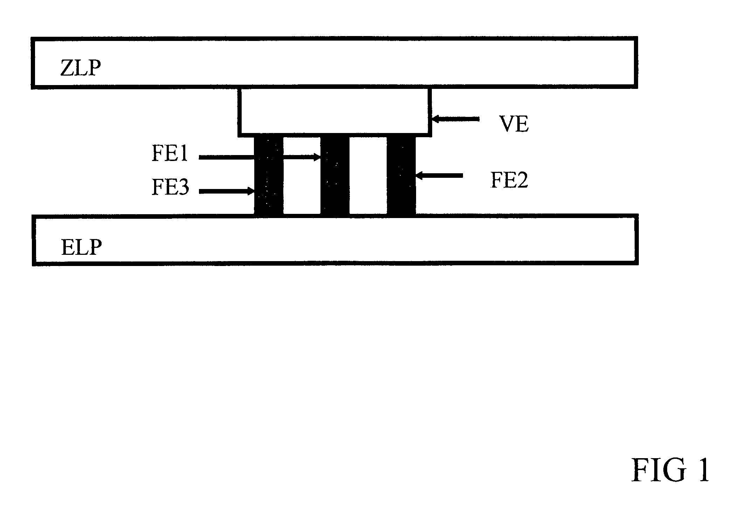

Die Figur 1 zeigt eine Anordnung, umfassend eine erste Leiterplatte ELP, eine zweite Leiterplatte ZLP und ein Verbindungselement VE, das drei Federelemente FE1, FE2, FE3 umfasst. Das Verbindungselement VE ist mit einer Seite, seinem Kopf, mit der zweiten Leiterplatte ZLP elektrisch kontaktiert. Die drei Federelemente FE1, FE2, FE3 des Verbindungselementes VE haben jeweils eine längliche Form, eine sogenannte Stiftform. Jeder der drei Federelemente FE1, FE2, FE3 ist mit der ersten Leiterplatte ELP elektrisch kontaktiert.

Die Verwendung von "federnden" Federelementen FE1, FE2, FE3 ist für die Erfindung nicht unerlässlich. Es könnten auch starre Federelemente, im normalen Sprachgebrauch dann besser als Elemente oder Verbindungsansätze bezeichnet, verwendet werden.

In der Praxis werden jedoch "federnde" Federelemente FE1, FE2, FE3 deshalb verwendet, da diese eine sicherere Kontaktierung zwischen Verbindungselement VE und erster Leiterplatte ELP gewährleisten, insbesondere wenn das Zusammenbringen von mit der zweiten Leiterplatte ZLP verbundenem Verbindungselement VE und erster Leiterplatte ELP durch Anpress-Kontaktierung ausgeführt wird.

"Federnde" Federelemente FE1, FE2, FE3 gewährleisten auch insofern eine sichere Kontaktierung als das Verdrehungen oder Verschiebungen zwischen der ersten und zweiten Leiterplatte ELP, ZLP besser kompensiert werden können, ohne dass die Kontaktierung abreißt.

In der Praxis soll die Erfindung für dem Fachmann bekannte Hochfrequenz-Board-to-Board-Leiterplatten geeignet sein.

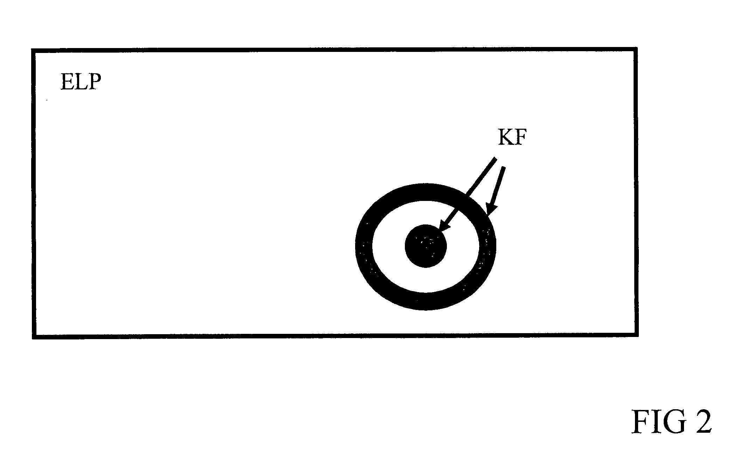

Die Figur 2 zeigt eine erste Leiterplatte ELP mit einer Kontaktfläche KF zur Kontaktierung des Verbindungselementes VE aus Figur 1. Die Kontaktfläche KF umfasst einen zentralen Kontaktpunkt und einen diesen zentralen Kontaktpunkt umgeben den konzentrischen Ring.

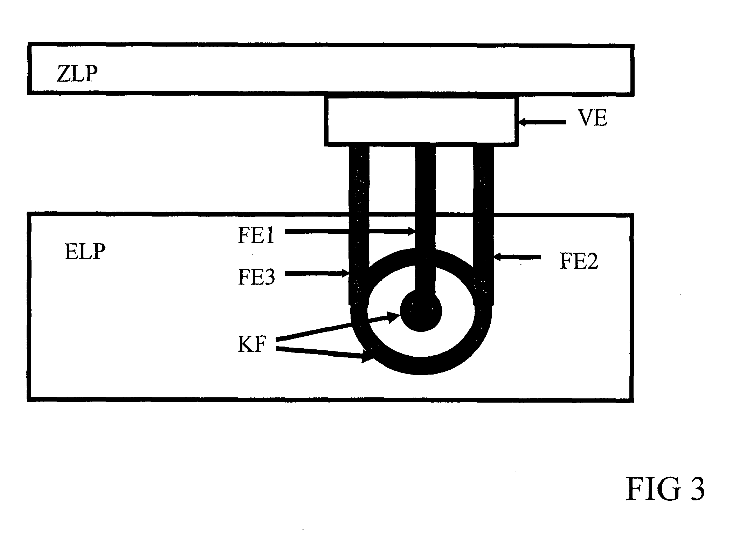

Die Figur 3 zeigt die Anordnung aus Figur 1 und die Kontaktfläche KF der ersten Leiterplatte ELP aus Figur 2 in Zusammenschau. Das Verbindungselement VE ist an der Oberseite mit der zweiten Leiterplatte ZLP elektrisch kontaktiert. An der der ersten Seite des Verbindungselementes VE gegenüberliegenden Seite, der Unterseite, befinden sich die drei Federelemente FE1, FE2, FE3. Das erste Federelement FE1 ist mit dem zentralen Kontaktpunkt der ersten Leiterplatte ELP elektrisch kontaktiert. Die beiden zweiten Federelemente FE2, FE3 sind mit dem konzentrischen Ring der ersten Leiterplatte ELP elektrisch kontaktiert.

Durch geschickte Wahl der Breite des zentralen Kontaktpunktes und der Breite des konzentrischen Ringes lassen sich viele bekannte Verbindungselemente VE mit Federelementen FE1, FE2, FE3 in Stiftform einsetzen. Auch soll von der Erfindung umfasst sein, wenn das Verbindungselement VE nur ein erstes Federelement FE1 und ein zweites Federelement FE2, FE3 umfasst. Da könnte man sich so vorstellen, dass das Federelement FE3 der Figur 3 nicht existiert (nicht in der Figur 3 gezeigt).

Wichtig für die Erfindung ist, dass, auch wenn die Leiterplatten ELP, ZLP (bzw. das mit der zweiten Leiterplatte ZLP fest verbundene Verbindungselement VE) zueinander verdreht (bis zu 360 Grad) kontaktiert werden sollen, dieses aufgrund der Form der Kontaktfläche KF der ersten Leiterplatte ELP ohne weiteres möglich ist. Wie bereits beschreiben gleichen die "federnden" Federelemente FE1, FE2, FE3 auch kleinere Abstandstoleranzen in lateraler Richtung und in vertikaler Richtung zwischen den Leiterplatten ELP, ZLP aus. Da in der Praxis zumeist die Form und Größe des Verbindungselementes VE, das mit der zweiten Leiterplatte ZLP fest verbunden ist, vorgegebenen ist, ermöglicht die spezielle geometrische Ausgestaltung der Kontaktfläche KF der ersten Leiterplatte ELP die Kontaktierung von verschiedenen vorgegebenen Verbindungselementen VE, ohne dass das Layout der ersten Leiterplatte ELP verändert werden müsste.

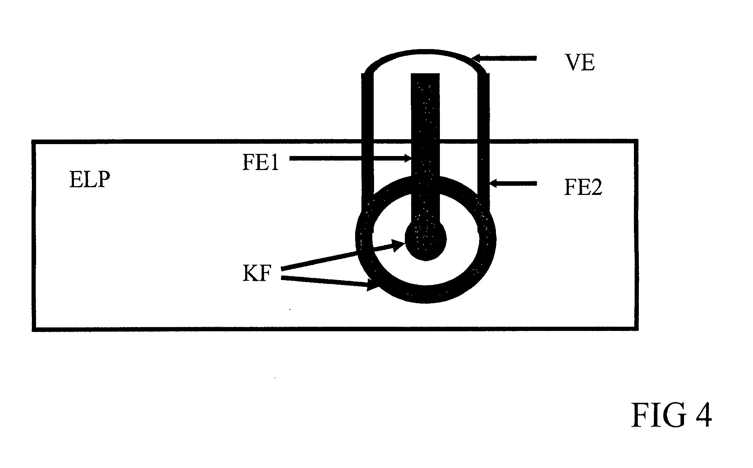

Die Figur 4 zeigt die Anordnung aus Figur 3 ohne die zweite Leiterplatte ZLP, aber mit einem zur Figur 3 alternativen Verbindungselement VE. Das Verbindungselement VE wird auf der Oberseite, wie in Figur 3 beschrieben, mit der zweiten Leiterplatte ZLP verbunden (hier nicht gezeigt). Zur besseren Veranschaulichung der Form des Verbindungselementes VE ist der obere Teil des Verbindungselementes VE und die Kontaktierung mit der zweiten Leiterplatte ZLP jedoch nicht gezeigt.

Das Verbindungselement VE umfasst zwei Federelemente FE1, FE2. Das erste Federelement FE1 ist als zentraler Stift ausgeführt und das zweite Federelement FE2 umgibt das erste Federelement FE1 konzentrisch. Dieser Typ von Verbindungselement VE wird allgemein als koaxiales Verbindungselement bezeichnet. Auch hier ergeben sich die erfindungsgemäßen Vorteile, dass eine Kontaktierung zwischen den Federelementen FE1, FE2 und der Kontaktfläche KF auch dann möglich ist, wenn die mit den Federelementen FE1, FE2 bzw. dem Verbindungselement VE fest verbundene zweite Leiterplatte ZLP verdreht mit der ersten Leiterplatte ELP kontaktiert werden soll. Die weiteren in den vorstehenden Figuren beschriebenen Überlegungen zur Ausgestaltung der Kontaktfläche KF bzw. der Federelemente FE1, FE2 gelten für das Verbindungselement VE der Figur 4 entsprechend.

Die Erfindung ist nicht auf das spezielle Ausführungsbeispiel beschränkt, sondern schließt weitere nicht explizit offenbarte Abwandlungen mit ein, solange von dem Kern der Erfindung Gebrauch gemacht wird. Das gilt insbesondere dann, wenn die Kontaktfläche KF keinen exakt konzentrischen Ring umfasst, sondern beispielsweise einen elliptischen oder vieleckigen, wobei aufgrund der Dimensionierung der Breite der Federelemente dennoch die erfindungsgemäße Wirkung erreicht wird.

## Patentansprüche

1. Anordnung, umfassend
- eine erste Leiterplatte (ELP), die eine Kontaktfläche (KF) zur Kontaktierung eines Verbindungselements (VE) aufweist, wobei die Kontaktfläche (KF) einen zentralen Kontaktpunkt und einen diesen zentralen Kontaktpunkt umgebenden konzentrischen Ring umfasst;
- eine zweite Leiterplatte (ZLP); und **gekennzeichnet durch**
- ein Verbindungselement (VE), das an einer ersten Seite mit der zweiten Leiterplatte (ZLP) elektrisch kontaktiert ist und an einer der ersten Seite gegenüber liegenden zweiten Seite ein erstes Federelement (FE1) und mindestens ein zweites Federelement (FE2, FE3) umfasst, wobei das erste Federelement (FE1) mit dem zentralen Kontaktpunkt der ersten Leiterplatte (ELP) und das mindestens eine zweite Federelement (FE2, FE3) mit dem konzentrischen Ring der ersten Leiterplatte (ELP) elektrisch kontaktiert ist.

2. Anordnung nach Anspruch 1, bei der das Verbindungselement (VE) das erste Federelement (FE1) und zwei zweite Federelemente (FE2, FE3) umfasst, wobei das erste Federelement (FE1) mit dem zentralen Kontaktpunkt und die beiden zweiten Federelemente (FE2, FE3) mit dem konzentrischen Ring elektrisch kontaktiert sind.

3. Anordnung nach Anspruch 1, bei der das zweite Federelement (FE2) das erste Federelement (FE1) konzentrisch umgibt.

## Claims

1. An arrangement, comprising
- a first printed circuit board (ELP) that has a contact surface (KF) for contacting a connection element (VE), wherein the contact surface (KF) comprises a central contact point and a concentric ring surrounding this central contact point;
- a second printed circuit board (ZLP); and **characterised by**
- a connection element (VE) which on a first side is electrically contacted with the second printed circuit board (ZLP) and on a second side lying opposite the first side comprises a first spring element (FE1) and at least one second spring element (FE2, FE3), wherein the first spring element (FE1) is electrically contacted with the central contact point of the first printed circuit board (ELP) and the at least one second spring element (FE2, FE3) is electrically contacted with the concentric ring of the first printed circuit board (ELP).

2. An arrangement according to claim 1, in which the connection element (VE) comprises the first spring element (FE1) and two second spring elements (FE2, FE3), wherein the first spring element (FE1) is electrically contacted with the central contact point and the two second spring elements (FE2, FE3) are electrically contacted with the concentric ring.

3. An arrangement according to claim 1, in which the second spring element (FE2) concentrically surrounds the first spring element (FE1).

## Revendications

1. Agencement, comprenant
- une première plaquette (ELP) à circuit imprimé, qui a une surface (KF) de contact pour la mise en contact avec un élément (VE) de liaison, la surface (KF) de contact comprenant un point central de contact et un anneau entourant ce point central de contact ;
- une deuxième plaquette (ZLP) à circuit imprimé ; et **caractérisé par**
- un élément (VE) de liaison, qui est mis en contact électriquement avec la deuxième plaquette (ZLP) à circuit imprimé sur une première face et qui comprend un premier élément (FE1) élastique et au moins un deuxième élément (FE2, FE3) élastique sur une deuxième face opposée à la première face, le premier élément (FE1) élastique étant mis en contact électriquement avec le point central de contact de la première plaquette (ELP) à circuit imprimé et le au moins un deuxième élément (FE2, FE3) élastique étant mis en contact électriquement avec l'anneau concentrique de la première plaquette (ELP) à circuit imprimé.

2. Agencement suivant la revendication 1, dans lequel l'élément (VE) de liaison comprend le premier élément (FE1) élastique et deux deuxièmes éléments (FE2, FE3) élastiques, le premier élément (FE1) élastique étant mis en contact électriquement avec le point central de contact et les deux deuxièmes éléments (FE2, FE3) élastiques étant mis en contact électriquement avec l'anneau concentrique.

3. Agencement suivant la revendication 1, dans lequel le deuxième élément (FE2) élastique entoure concentriquement le premier élément (FE1) élastique.
